# EUROPÄISCHE PATENTANMELDUNG

(11) **EP 1 134 788 A1**
(43) Veröffentlichungstag der Anmeldung: **19.09.2001**
(21) Anmeldenummer: 00810229.5
(22) Anmeldetag: 17.03.2000
(51) Int. Cl.: H01L 21/00

(54) **Einrichtung für die Montage von Halbleiterchips auf einem Substrat**

(71) Anmelder: ESEC Trading SA, 6330 Cham (CH)
(72) Erfinder: Mannhart, Eugen, Dr., 6330 Cham (CH); Enzler, August, 6331 Hünenberg (CH); Odermatt, André, 6331 Hünenberg (CH)
(74) Vertreter: Falk, Urs, Dr.

(57) **Zusammenfassung**

Die Erfindung betrifft eine Einrichtung für die Montage von Halbleiterchips auf einem Substrat (1), bei der das Substrat (1) taktweise in einer ersten Richtung (x) zu einer Bondstation vorgeschoben wird zur Bereistellung eines nächsten Substratplatzes (2). Damit gekrümmte oder auch sonst in ihrer Lage quer zur Transportrichtung leicht verschobene Substrate lagegenau am Bondort bereitgestellt werden können, wird vorgeschlagen, die Lage der Längskante (4) des Substrates (1) quer zur Transportrichtung (y) auf der Höhe der Bondstation zu messen und anschliessend mit dem Substrat (1) eine Korrekturbewegung durchzuführen. Als Sensor (12) wird ein optischer Sensor mit zwei nebeneinander angeordneten Lichtschranken vorgeschlagen.

## Beschreibung

Die Erfindung betrifft eine Einrichtung für die Montage von Halbleiterchips auf einem Substrat der im Oberbegriff des Anspruchs 1 genannten Art.

Solche Montageautomaten sind allgemein als Die Bonder bekannt. Bei der Montage der Halbleiterchips wird das Substrat von einer Transporteinrichtung taktweise einer Dispensstation, wo Klebstoff aufgetragen wird, und dann einer Bondstation zugeführt, wo der nächste Halbleiterchip plaziert wird. Aus dem europäischen Patent EP 330831 und dem schweizerischen Patent CH 689188 sind Transporteinrichtungen bekannt geworden, bei denen die Ausrichtung des Substrates quer zur Transportrichtung auf mechanische Weise erfolgt, indem das Substrat gegen einen Anschlag gezogen wird. Nachteilig bei dieser Lösung ist, dass sich gewisse Substrate wölben, wenn sie gegen den Anschlag gezogen werden. Andererseits sind Montageautomaten im Handel, bei denen die Lage des Substrates unmittelbar vor dem Plazieren des nächsten Halbleiterchips mittels einer Kamera und elektronischer Bildverarbeitung bestimmt und auskorrigiert wird. Eine solche Lösung ist bekannt aus der europäischen Patentanmeldung EP 877544. Diese Lösung hat zwei erhebliche Nachteile: Sie ist zeitintensiv, was auf Kosten der Zykluszeit geht, und teuer. Von Montageautomaten werden aber hohe Plazierungsgenauigkeit und kurze Zykluszeiten verlangt.

Der Erfindung liegt die Aufgabe zugrunde, die Plazierungsgenauigkeit der montierten Halbleiterchips bei kurzer Zykluszeit zu verbessern.

Die Erfindung besteht in den im Anspruch 1 angegebenen Merkmalen. Vorteilhafte Ausgestaltungen ergeben sich aus den abhängigen Ansprüchen.

Die Erfindung geht aus von der Entdeckung, dass gewisse metallische Leadframes erheblich gekrümmt sind. Diese Krümmung ist zwar von Auge nicht sichtbar, führt aber dazu, dass der Substratplatz, auf dem der nächste Halbleiterchip plaziert werden soll, quer zur Transportrichtung gegenüber seiner Solllage verschoben ist. Die Erfindung schlägt vor, die Lage der Längskante des Leadframes quer zur Transportrichtung auf der Höhe der Bondstation zu messen und anschliessend mit dem Substrat eine Korrekturbewegung durchzuführen, damit der Substratplatz lagegenau am richtigen Ort zum Bonden bereitgestellt wird. Für diese Messung wird ein optischer Sensor mit zwei nebeneinander angeordneten Lichtschranken vorgeschlagen.

Nachfolgend wird ein Ausführungsbeispiel der Erfindung anhand der Zeichnung näher erläutert. Die Figuren sind nicht massstabsgetreu.

Es zeigen:
- Fig. 1: Teile einer Einrichtung für die Montage von Halbleiterchips und ein Leadframe,
- Fig. 2: ein weiteres Leadframe,
- Fig. 3: einen Sensor,
- Fig. 4: eine elektronische Schaltung,
- Fig. 5: eine Kalibrierungsplatte, und
- Fig. 6: eine Einrichtung mit zwei Sensoren.

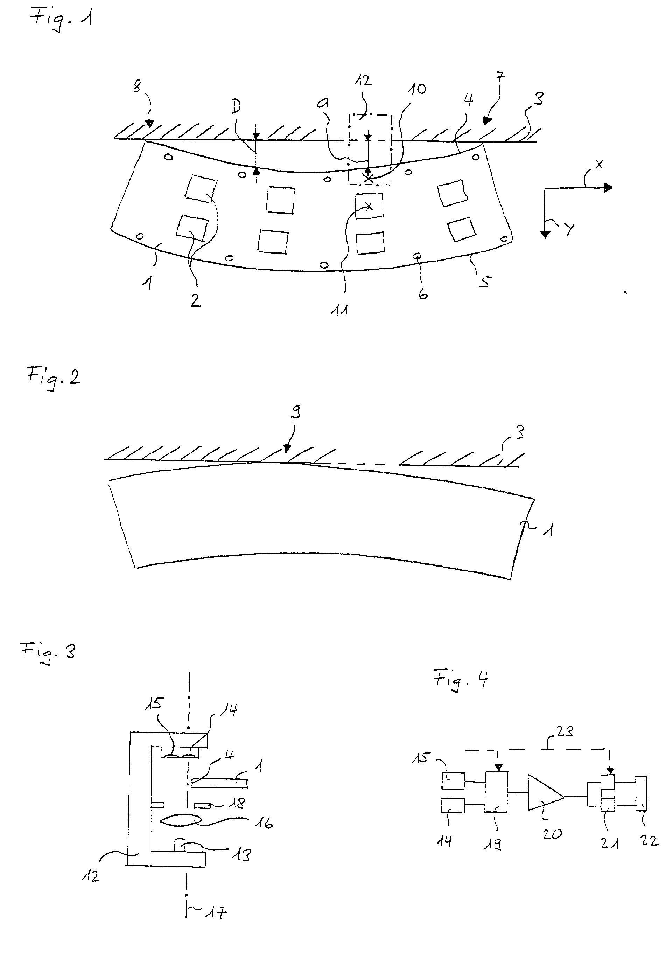

Die Fig. 1 zeigt die für das Verständnis der Erfindung nötigen Teile einer Einrichtung für die Montage von Halbleiterchips auf einem Substrat. Das Substrat ist ein längliches, metallisches Leadframe 1 mit einer Anzahl von hintereinander und nebeneinander angeordneten Chipinseln 2, auf denen je ein Halbleiterchip plaziert werden soll. Das Leadframe 1 ist nur schematisch dargestellt. Die Einrichtung umfasst ein Transportsystem für den Transport des Leadframes 1, eine Dispensstation für das Auftragen von Klebstoff auf das Leadframe 1 und eine Bondstation, an der ein Pick and Place System einen Halbleiterchip nach dem andern auf dem Leadframe 1 plaziert.

Das Leadframe 1 befindet sich dabei stets in einer horizontalen Transportebene xy und wird in einer Transportrichtung x bewegt. Das Leadframe 1 liegt auf einer heizbaren Auflageplatte auf, welche eine horizontale Verschiebebahn für das Leadframe 1 bildet und in der Transportebene xy liegt, und wird vorzugsweise mittels eines System feststehender und beweglicher Klammern schrittweise in Transportrichtung x der Dispensstation und der Bondstation zugeführt. Ein solches Transportsystem ist im europäischen Patent EP 330831 beschrieben und wird deshalb hier nicht näher erläutert. Der Transport des Leadframes 1 könnte auch mittels eines Transportsystems erfolgen, das nur eine einzige, bewegliche Klammer aufweist. Das Leadframe 1 wird von den Klammern bzw. der Klammer, falls nur eine einzige Klammer vorhanden ist, in seitlicher Richtung, d.h. in negativer y-Richtung gegen eine parallel zur Transportrichtung x angeordnete, als Anschlag dienende Führungsschiene 3 gezogen und dadurch an dieser ausgerichtet. Das Leadframe 1 weist entlang seiner Längskanten 4 und 5 Löcher 6 auf, die von einem nicht dargestellten optischen Sensor abgetastet und für die genaue Positionierung des Leadframes 1 in Transportrichtung x benützt werden.

Das in der Fig. 1 gezeichnete Leadframe 1 ist gekrümmt, wobei die Krümmung stark übertrieben dargestellt ist. Daher liegen nur ein vorderer und ein hinterer Kantenbereich 7 bzw. 8 der Längskante 4 des Leadframes 1 an der Führungsschiene 3 an. Der Abstand D der Längskante 4 des Leadframes 1 von der Führungsschiene 3 ist nicht konstant, sondern ortsabhängig. Er kann bis zu 80 µm betragen. Demzufolge unterliegt der Abstand der Chipinseln 2 von der Führungsschiene 3 gewissen Schwankungen. Falls das Leadframe 1, wie in der Fig. 2 gezeigt ist, auf die andere Seite gekrümmt ist, liegt nur ein Kantenbereich 9 an der Führungsschiene 3 an.

In der Fig. 1 ist nun mit einem ersten Kreuz 10 die Ist-Position markiert, an der das Pick and Place System den nächsten Halbleiterchip plazieren wird, sofern keine Korrekturmassnahmen ergriffen werden. Wegen der Krümmung des Leadframes 1 ist die Ist-Position nicht in Übereinstimmung mit der mit einem zweiten Kreuz 11 markierten Soll-Position, die der Halbleiterchip auf dem Leadframe 1 einnehmen soll: Die Ist-Position ist gegenüber der Soll-Position um die Distanz a verschoben, wobei die Distanz a den aktuellen Abstand der Längskante 4 des Leadframes 1 von der Führungsschiene 3 am Ort der Bondstation bezeichnet. Um vor dem Plazieren des nächsten Halbleiterchips die Ist-Position mit der Soll-Position in Einklang zu bringen, ist vorgesehen, jeweils den Abstand a mittels eines Sensors 12 zu messen und anschliessend die Führungsschiene 3 und die Klammer quer zur Transportrichtung x, nämlich in negativer Richtung y, um den gemessenen Abstand a zu verschieben. Dabei wird das von der Klammer gegen die Führungsschiene 3 gezogene Leadframe 1 mitverschoben und die Abweichung zwischen der Ist-Position und der Soll-Position zum Verschwinden gebracht.

Die Fig. 3 zeigt einen für die Messung des Abstandes a geeigneten Sensor 12 im Querschnitt entlang der y-Richtung. Der Sensor 12 ist an der Führungsschiene 3 (Fig. 1) befestigt. Im Bereich des Sensors 12 ist die Führungsschiene 3 mit einer Ausnehmung versehen. Der Sensor 12 weist eine Lichtquelle 13 und zwei nebeneinander angeordnete Lichtempfänger 14 und 15 auf, so dass zwei Lichtschranken gebildet werden. Im Strahlengang zwischen der Lichtquelle 13 und den beiden Lichtempfängern 14 und 15 ist vorzugsweise eine Linse 16 so angeordnet, dass sich die Lichtquelle 13 im Brennpunkt der Linse 16 befindet. Die Linse 16 bündelt das von der Lichtquelle 13 ausgestrahlte Licht in parallele Lichtstrahlen, die im Bereich der Längskante 4 annähernd senkrecht auf das Leadframe 1 auftreffen. Die Ebene der Führungsschiene 3, an der die Kantenbereiche 7 und 8 des in der Fig. 1 dargestellten Leadframes 1 anliegen, ist mit einer gestrichelten Linie 17 eingezeichnet. Die beiden Lichtempfänger 14 und 15 weisen typischerweise Abmessungen von je 1 mm x 1 mm auf. Der Sensor 12 und die Führungsschiene 3 sind so aufeinander ausgerichtet, dass das Leadframe 1 nur Strahlen unterbricht, die von der Linse 16 zum ersten Lichtempfänger 14 verlaufen, nicht aber Strahlen, die von der Linse 16 zum zweiten Lichtempfänger 15 verlaufen. D.h. der Schatten des mit der Lichtquelle 13 beleuchteten Leadframes 1 fällt immer auf den ersten Lichtempfänger 14, während der zweite Lichtempfänger 15 nicht beschattet wird.

Die entlang der Längskanten 4, 5 des Leadframes 1 angebrachten Löcher 6 sind nur 0.4 mm vom Rand entfernt. Im Strahlengang zwischen der Linse 16 und dem Lichtempfänger 14 sind vorzugsweise eine oder mehrere Blenden 18 angeordnet, damit entweder kein von der Lichtquelle 13 abgestrahltes Licht durch ein solches Loch 6 gelangen kann oder dass allenfalls durch ein solches Loch 6 gelangtes Licht nicht auf den Lichtempfänger 14 fällt. Im Strahlengang können fakultativ weitere optische Elemente vorgesehen sein.

Der zweite Lichtempfänger 15 dient als Referenz, so dass Schwankungen der Helligkeit der Lichtquelle 13 und Schwankungen der Empfindlichkeit des Lichtempfängers 14 kompensiert werden können. Die beiden Lichtempfänger 14 und 15 befinden sich auf demselben Halbleiterchip, damit sie möglichst die gleiche Licht- und die gleiche Temperaturempfindlichkeit aufweisen. Die beiden Lichtschranken werden mit der Lock-In Technik betrieben, wobei die Amplitude des die Lichtquelle 13 speisenden Stromes beispielsweise mit einer Frequenz von 200 kHz moduliert wird. Bevorzugt wird als Lichtquelle 13 eine Leuchtdiode verwendet, da die Amplitude einer Leuchtdiode zu 100 % moduliert werden kann, während bei einer Laserdiode nur eine Modulation der Amplitude von wenigen Prozent möglich ist. Zudem werden die Signale der beiden Lichtempfänger 14 und 15, wie in der Fig. 4 dargestellt ist, bevorzugt einem Multiplexer 19 zugeführt, dann in einem gemeinsamen Verstärker 20 verstärkt, in einem Demultiplexer 21 wieder getrennt und schliesslich einem A/D-Wandler 22 zugeführt, so dass sich Schwankungen im Verstärkerkreis auf beide Signale gleichermassen auswirken. Die Steuerleitung für den Multiplexer 19 und den Demultiplexer 21 ist mit dem Bezugszeichen 23 bezeichnet. Das Verhältnis des Signals des ersten Lichtempfängers 14 zum Signal des zweiten, als Referenz dienenden Lichtempfängers 15 bildet das Ausgangssignal U_{A} des Sensors 12, das ein Mass für den Grad der Abdeckung des ersten Lichtempfängers 14 durch das Leadframe 1 darstellt.

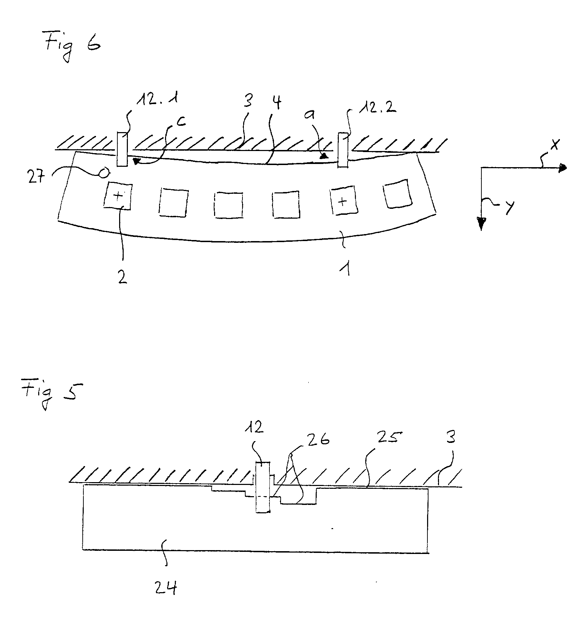

Die Kennlinie U_{A}(a), die die Beziehung zwischen dem Ausgangssignal U_{A} des Sensors 12 (Fig. 1) und dem Abstand a der Längskante 4 des Leadframes 1 von der Führungsschiene 3 darstellt, kann beispielsweise mittels einer einem Leadframe ähnlichen Kalibrierungsplatte 24 erfolgen, die, wie in der Fig. 5 gezeigt ist, eine gerade Längskante 25 mit um vorbestimmte Werte zurückversetzten geraden Kantenabschnitten 26 aufweist. Bei der Aufnahme der Kennlinie U_{A}(a) wird die Kalibrierungsplatte 24 an der Führungsschiene 3 zum Anschlag gebracht, und das Ausgangssignal U_{A} für mindestens zwei verschiedene Kantenabschnitte 26 gemessen und gespeichert.

Im Normalbetrieb wird aus dem gemessenen Ausgangssignal U_{A} und der gespeicherten Kennlinie U_{A}(a) durch Interpolation der aktuelle Abstand a berechnet und die Verschiebung der Führungsschiene 3, der Klammer und des Leadframes 1 um den ermittelten Abstand a in y-Richtung durchgeführt. Sobald diese Korrekturbewegung abgeschlossen ist, kann der Halbleiterchip am richtigen Ort auf dem Leadframe 1 plaziert werden.

Die Fig. 6 zeigt eine Einrichtung für die Montage von Halbleiterchips auf einem Leadframe 1, die zwei ortsfest angeordnete Sensoren 12.1 und 12.2 für die Messung des Abstandes der der Führungsschiene 3 zugewandten Längskante 4 des Leadframes 1 aufweist. Die Einrichtung weist eine Dispensstation auf mit einem in der Horizontalebene beweglich geführten Schreibkopf 27, um auf die Chipinsel 2 Klebstoff gemäss einem vorbestimmten Muster aufzutragen, und die Bondstation. Eine solche Dispensstation ist z.B. in der europäischen Patentanmeldung EP 901155 beschrieben, auf die hiermit Bezug genommen wird. Der Sensor 12.1 befindet sich am Ort der Dispensstation, um dort den Abstand c der Längskante 4 des Leadframes 1 von der Führungsschiene 3 zu messen. Der Sensor 12.2 dient, wie oben beschrieben, zur Messung des Abstandes a der Längskante 4 des Leadframes 1 von der Führungsschiene 3 am Ort der Bondstation.

Wenn nun in einem Bondzyklus der Abstand a gemessen wurde, dann wird die Führungsschiene 3 in y-Richtung quer zur Transportrichtung x des Leadframes 1 verschoben. Dabei ändert sich natürlich die relative Lage des Schreibkopfs 27 der Dispensstation bezüglich der Chipinsel 2. Beim Auftragen des Klebstoffs auf die Chipinsel 2 wird der Schreibkopf 27 unter Berücksichtigung sowohl des mit dem Sensor 12.1 gemessenen Abstandes c der Chipinsel 2 von der Führungsschiene 3 als auch der den Abstand a kompensierenden Korrekturbewegung der Führungsschiene 3 in y-Richtung gesteuert.

Dank der Erfindung können gekrümmte, oder z.B. vom Schliessen und Öffnen der Transportklammern in ihrer Lage leicht verschobene Leadframes mikrometergenau am Bondort bereitgestellt werden.

## Patentansprüche

1. Einrichtung für die Montage von Halbleiterchips auf einem Substrat, insbesondere einem metallischen Leadframe (1), bei der das Substrat taktweise in einer ersten Richtung (x) zu einer Bondstation vorgeschoben wird zur Bereitstellung eines nächsten Substratplatzes (2), **dadurch gekennzeichnet, dass** ein Sensor (12) vorhanden ist für die Ermittlung der Lage einer Längskante (4) des Substrates (1) bezüglich einer zweiten, zur ersten Richtung orthogonalen Richtung (y).

2. Einrichtung nach Anspruch 1, **dadurch gekennzeichnet, dass** der Sensor (12) eine aus einer Lichtquelle (13) und einem ersten Lichtempfänger (14) gebildete erste Lichtschranke und eine aus der Lichtquelle (13) und einem zweiten Lichtempfänger (15) gebildete zweite, als Referenz dienende Lichtschranke aufweist, und dass der Sensor (12) so angeordnet ist, dass das Substrat im Betrieb die erste Lichtschranke teilweise, die zweite Lichtschranke nicht abdeckt.

3. Einrichtung nach Anspruch 1 oder 2, **dadurch gekennzeichnet, dass** der erste und der zweite Lichtempfänger (14, 15) nebeneinander auf demselben Halbleiterchip integriert sind.

4. Einrichtung nach Anspruch 2 oder 3, **dadurch gekennzeichnet, dass** eine Linse (16) vorhanden ist, die so angeordnet ist, dass sich die Lichtquelle (13) im Brennpunkt der Linse (16) befindet.

5. Einrichtung nach einem der Ansprüche 2 bis 4, **dadurch gekennzeichnet, dass** das Signal des ersten Lichtempfängers (14) und das Signal des zweiten Lichtempfängers (15) einem Multiplexer (19) zugeführt sind, und dass dem Multiplexer (19) ein gemeinsamer Verstärker (20) nachgeschaltet ist.

6. Einrichtung nach einem der Ansprüche 2 bis 5, **dadurch gekennzeichnet, dass** die Lichtquelle (13) eine Leuchtdiode ist.

7. Einrichtung nach einem der Ansprüche 1 bis 6, **dadurch gekennzeichnet, dass** im Normalbetrieb die Lage der Längskante (4) des Substrates (1) bezüglich der zweiten Richtung (y) mit dem Sensor (12) erfasst und anschliessend eine Korrekturbewegung des Substrats in der zweiten Richtung (y) durchgeführt wird, um den nächsten Substratplatz (2) am richtigen Ort bereitzustellen.
